(19) Europäisches Patentamt
European Patent Office
Office européen des brevets

(11) **EP 3 694 005 B1**

(12) **EUROPÄISCHE PATENTSCHRIFT**

(45) Veröffentlichungstag und Bekanntmachung des Hinweises auf die Patenterteilung:
**01.12.2021 Patentblatt 2021/48**

(51) Int Cl.:
*H01L 33/10* (2010.01)  *H01L 33/46* (2010.01)
*H01S 5/34* (2006.01)  *H01S 5/04* (2006.01)
*H01S 5/042* (2006.01)  *H01S 5/14* (2006.01)
*H01S 5/183* (2006.01)  *H04B 10/70* (2013.01)
*H01S 5/10* (2021.01)

(21) Anmeldenummer: **19155703.2**

(22) Anmeldetag: **06.02.2019**

(54) **VORRICHTUNG UND VERFAHREN ZUR ERZEUGUNG EINER EINZELPHOTONENEMISSION**

DEVICE AND METHOD FOR PRODUCING A SINGLE PHOTON EMISSION

DISPOSITIF ET PROCÉDÉ DE GÉNÉRATION D'UNE ÉMISSION DE PHOTONS INDIVIDUELLES

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**12.08.2020 Patentblatt 2020/33**

(73) Patentinhaber: **Universität Stuttgart**
**70174 Stuttgart (DE)**

(72) Erfinder:
• **MICHLER, Peter**
**70806 Kornwestheim (DE)**
• **JETTER, Michael**
**72654 Neckartenzlingen (DE)**
• **HERZOG, Thomas**
**73765 Neuhausen (DE)**

• **PAUL, Matthias**
**97941 Tauberbischofsheim (DE)**

(74) Vertreter: **Müller-Boré & Partner**
**Patentanwälte PartG mbB**
**Friedenheimer Brücke 21**
**80639 München (DE)**

(56) Entgegenhaltungen:
**DE-A1-102012 007 793  US-A1- 2018 108 804**

• **DIRK HEINZE ET AL: "A quantum dot single-photon source with on-the-fly all-optical polarization control and timed emission", ARXIV.ORG, CORNELL UNIVERSITY LIBRARY, 201 OLIN LIBRARY CORNELL UNIVERSITY ITHACA, NY 14853, 2. Dezember 2014 (2014-12-02), XP081396958, DOI: 10.1038/NCOMMS9473**

EP 3 694 005 B1

**Beschreibung**

Die Erfindung betrifft eine Vorrichtung und ein Verfahren zur Erzeugung einer Einzelphotonenemission.

Die Erzeugung einzelner, ununterscheidbarer Photonen mit hoher Brillanz ist von großem Interesse im Hinblick auf vielfältige Anwendungen, insbesondere im Bereich der Quanteninformationstechnologien. Hierzu gehören z.B. Anwendungen im Bereich des Quanten-Repeaters, der Quantensimulation, des Quantenrechnens, usw.

Aus dem Stand der Technik ist bisher lediglich ein theoretisches Konzept für eine Einzelphotonenquelle bekannt, bei der die Wellenlänge, die Pulsbreite und die Polarisation der Einzelphotonenemission gleichzeitig eingestellt werden können. Dieses Konzept, welches in dem Artikel D. Heinze et al: "A quantum dot single-photon source with on-the-fly all-optical polarization control and timed emission", Nature Communications 6, 8473, DOI: 10.1038/ncomms9473 (2015) und auch in der DE 10 2012 007 793 A1 beschrieben ist, schlägt vor, einen externen Laser zur Stimulation eines Zwei-Photonenübergangs eines Biexzitons zu verwenden, um letztlich einzelne Photonen zu erzeugen, deren Eigenschaften durch den Stimulationslaser vorgegeben werden.

Dirk Heinze et al.: "A quantum dot single-photon source with on-the-fly all-optical polarization control and timed emission", arxiv.org, Cornell Univ. Library, 201 OLIN Library Cornell Univ. ITHACA, NY 14853, 2. Dezember 2014, XP081396958, offenbart das gleiche Anregungsschema der DE 10 2012 007 793 A1, mit einer Anregungsquelle, die im aktiven Medium ein Biexziton erzeugt und einer Pumpquelle, die das aktive Medium mit Stimulationslicht bestrahlt und aus dem Biexzitons einen virtuellen Zustand $X_H$ oder $X_V$ erzeugt, aus dem heraus das Einzelphoton emittiert wird.

Die in den oben genannten Druckschriften vorgeschlagene technische Umsetzung beruht auf der Verwendung eines Einzelresonators, der auf die Wellenlänge der gewünschten Einzelphotonenemission eingestellt ist.

Bisher gibt es jedoch noch keinen Bericht zu einer praktisch realisierten Einzelphotonenquelle dieser Art.

Es ist daher eine Aufgabe der vorliegenden Erfindung, eine Vorrichtung und ein Verfahren zur Erzeugung einer Einzelphotonenemission bereitzustellen, welche praktisch umsetzbar ist.

Diese Aufgabe wird durch die Gegenstände der nebengeordneten Ansprüche gelöst. Vorteilhafte Ausführungsformen sind Gegenstand der Unteransprüche.

Ein erster unabhängiger Aspekt zur Lösung der Aufgabe betrifft eine Vorrichtung zum Erzeugen eines Einzelphotons, aufweisend:

- ein zu einem Biexziton-Zustand anregbares aktives Medium;

- eine Anregungsquelle, welche ausgelegt ist, um auf Basis des aktiven Mediums ein Biexziton zu erzeugen;
- eine Stimulationslichtquelle, welche ausgelegt und angeordnet ist, um das aktive Medium mit Stimulationslicht zu bestrahlen und somit auf Basis des erzeugten Biexzitons einen virtuellen Zustand zu erzeugen, aus dem heraus das Einzelphoton emittierbar ist;

wobei die Vorrichtung ferner einen Doppelresonator aufweist, in dem das aktive Medium angeordnet ist, wobei der Doppelresonator zwei gekoppelte Resonatormoden aufweist, wobei die erste Resonatormode auf eine Wellenlänge der Stimulationslichtquelle abgestimmt ist und wobei die zweite Resonatormode auf eine gewünschte Wellenlänge des emittierten Einzelphotons abgestimmt ist.

Ein aktives Medium oder eine aktive Schicht im Sinne der vorliegenden Erfindung umfasst ein System, welches zu einem Biexziton-Zustand anregbar ist. Ein solches System kann beispielsweise durch einen Quantenpunkt bzw. Halbleiterquantenpunkt realisiert sein. Das aktive Medium kann somit z.B. einen oder mehrere Quantenpunkte, insbesondere Halbleiterquantenpunkte, umfassen. Das aktive Medium kann z.B. ein Substrat, insbesondere ein Halbleitersubstrat, welches ein oder mehrere Quantenpunkte umfasst, sein. Mit anderen Worten sind ein oder mehrere Quantenpunkte auf dem Substrat angeordnet bzw. in dem Substrat integriert.

Ein Quantenpunkt ist eine nanoskopische Materialstruktur, meist aus Halbleitermaterial wie z.B. einem III-V-Halbleitermaterial oder einem II-VI-Halbleitermaterial. Ein Quantenpunkt aus einem III-V-Halbleitermaterial kann z.B. Aluminium, Gallium oder Indium (als III-Halbleiter) und Stickstoff, Phosphor oder Arsen (als V-Halbleiter) umfassen. Ein Quantenpunkt aus einem II-VI-Halbleitermaterial kann z.B. Zink oder Cadmium (als II-Halbleiter) und Selen oder Tellur (als VI-Halbleiter) umfassen. Je nach verwendetem Material ist die Wellenlänge der Photonen, welche von den Quantenpunkten emittiert werden, unterschiedlich. Vorzugsweise können für die vorliegende Erfindung In(Ga)As/GaAs Quantenpunkte verwendet werden, da sich im Rahmen der vorliegenden Erfindung bei solchen Quantenpunkten eine besonders gute Qualität der emittierenden Photonen herausgestellt hat. Es versteht sich, dass grundsätzlich auch beliebige andere Quantenpunkte für die vorliegende Erfindung verwendet werden können. Ladungsträger, d.h. Elektronen und Löcher, in einem Quantenpunkt sind in ihrer Beweglichkeit in allen drei Raumrichtungen so weit eingeschränkt, dass ihre Energie nicht mehr kontinuierliche, sondern nur noch diskrete Werte annehmen kann. Quantenpunkte verhalten sich also ähnlich wie Atome, jedoch kann ihre Form, Größe oder die Anzahl von Elektronen in ihnen beeinflusst werden. Dadurch lassen sich elektronische und optische Eigenschaften von Quantenpunkten maßschneidern. Typischerweise besteht ein Quantenpunkt aus etwa 10$^4$ Atomen, so dass solche Strukturen nur wenige Nanometer groß sind.

Die vorliegende Erfindung ist aber nicht auf Halbleiterquantenpunkte beschränkt, sondern grundsätzlich mit allen Systemen anwendbar, die sich zu einem Biexziton-Zustand anregen lassen. Ein weiteres System, mit denen sich Biexziton-Zustände realisieren lassen, wäre beispielsweise die Gruppe der Dichalcogenide. Die Herstellung eines aktiven Mediums bzw. von Quantenpunkten, die zu einem Biexziton anregbar sind, ist dem Fachmann bekannt und wird daher in dieser Beschreibung nicht weiter erläutert.

Ein Exziton ist ein gebundener Zustand eines Elektrons und eines Lochs in einem Festkörper, insbesondere Isolator oder Halbleiter. Ein solcher Zustand kann nur durch Emission eines einzelnen Photons zerfallen. Besonders leicht lassen sich solche Exziton-Zustände in Halbleiterquantenpunkten erzeugen. Jedoch gibt es grundsätzlich auch andere Möglichkeiten, solche Zustände zu erzeugen. Ein Exziton ist somit eine elementare Anregung des Festkörpers und außerdem, wie ein Phonon oder ein Polaron, ein Quasiteilchen.

Ein Biexziton ist ein Quasiteilchen, welches zwei Exzitonen umfasst bzw. aus zwei Exzitonen gebildet ist. Ein Biexziton-Zustand ist also ein Zustand von zwei gebundenen Elektron-Loch-Paaren.

Die Anregungsquelle kann eine optische oder eine elektrische Anregungsquelle sein. Insbesondere kann die Anregungsquelle eine Anregungslichtquelle und/oder eine Spannungsquelle umfassen bzw. sein. Entsprechend kann die Anregung des Biexziton-Zustands optisch und/oder elektrisch erfolgen. Unter einer Anregungslichtquelle, welche insbesondere ein Anregungslaser sein kann, wird im Sinne dieser Erfindung eine Lichtquelle verstanden, die Anregungslicht mit einer Frequenz aussendet, welche geeignet ist, um das aktive Medium bzw. den zumindest einen Quantenpunkt des aktiven Mediums anzuregen und ein Biexziton zu erzeugen. Die Anregungslichtquelle ist vorgesehen, um das aktive Medium bzw. den zumindest einen Quantenpunkt mit Anregungslicht zu bestrahlen. Ferner ist die Anregungslichtquelle in ihrer Frequenz derart abgestimmt, um ein Biexziton zu erzeugen. Das Biexziton kann z.B. durch einen Zwei-Photonen-Absorptionsprozess erzeugt werden. Bei dieser Zwei-Photonen-Absorbtion ist die Energie der eingestrahlten Photonen und damit die Frequenz des Anregungslichts auf die halbe Energiedifferenz zwischen Biexziton-Zustand und Grundzustand des Systems abgestimmt. Alternativ kann der Biexziton-Zustand auch durch eine resonante Ein-Photon-Anregung eines Ein-Exziton-Zustands des Systems und eine weitere Ein-Photon-Anregung des Systems von diesem Ein-Exziton-Zustand in den Biexziton-Zustand erzeugt werden. Eine weitere Möglichkeit zum Erzeugen des Biexzitons besteht darin, dass das System in den Biexziton-Zustand relaxiert, nachdem das System über den Biexziton-Zustand hinaus angeregt wurde. Alternativ kann das Biexziton elektrisch angeregt werden, indem das aktive Medium bzw. die Quantenpunkte mit kurzen Pulsen elektrisch getrieben werden. Insbesondere sind hierzu das aktive Medium bzw. die Quantenpunkte als eine pin-Struktur ausgebildet bzw. angeordnet.

Unter einer Stimulationslichtquelle, welche insbesondere ein Stimulationslaser sein kann und neben der Anregungslichtquelle eine weitere Lichtquelle darstellt, wird im Sinne dieser Erfindung eine Lichtquelle verstanden, die Stimulationslicht mit einer Frequenz aussendet, welche geeignet ist, um einen Übergang vom Biexziton-Zustand in einen virtuellen Zustand hervorzurufen. Dieser Übergang findet insbesondere dadurch statt, dass ausgehend vom erzeugten Biexziton ein erstes Photon (welches noch nicht dem zu erzeugenden Einzel-Photon entspricht) durch stimulierte Emission emittiert wird. Hierbei sei angemerkt, dass der Biexziton-Zustand nicht durch Emission von einzelnen Photonen relaxieren kann, die der Energie des Biexzitons entsprechen. Vielmehr kann ein Zerfall eines solchen Biexzitons nur durch zwei gleichzeitig emittierte Photonen in den Grundzustand oder durch ein Photon in einen Ein-Exziton Zwischenzustand erfolgen. Dies liegt daran, dass sowohl der Biexziton-Zustand als auch der Grundzustand eines solchen Systems Spin Null haben und damit ein Übergang vom Biexziton-Zustand in den Grundzustand durch Aussenden nur eines einzigen Photons quantenmechanisch nicht erlaubt ist. Erfindungsgemäß findet ein Zerfall des Biexzitons über einen virtuellen Zwischenzustand statt, wobei sich der virtuelle Zwischenzustand energetisch in der Regel von dem Exziton-Zustand unterscheidet. Die Stimulationslichtquelle ist vorgesehen, um das aktive Medium mit Stimulationslicht zu bestrahlen und in ihrer Frequenz derart abgestimmt, um auf Basis des erzeugten Biexzitons einen virtuellen Zustand zu erzeugen. Aus dem virtuellen Zustand heraus kann schließlich das gewünschte Einzelphoton, insbesondere spontan, emittieren.

Unter dem virtuellen Zustand wird insbesondere ein Zustand verstanden, der als stationärer quantenmechanischer Zustand in dem betrachteten System nicht vorkommt, jedoch in den Grenzen der Unschärferelation ansonsten nicht erlaubte Übergänge vermittelt.

Unter einem Doppelresonator wird im Sinne dieser Erfindung ein Resonator verstanden, welcher gekoppelte Moden, im Folgenden Doppel-Mode genannt, aufweist. Die Doppel-Mode umfasst zwei Resonatormoden, nämlich die bereits oben erwähnte erste und zweite Resonatormode. Mit anderen Worten weist der Doppelresonator ein Reflektionsspektrum mit einem Doppel-Dip auf. Die beiden Resonatormoden treten im Reflektivitätsspektrum des Doppelresonators als Doppel-Mode bzw. in Form eines Doppel-Dips auf, d.h. als eng beieinander liegende Resonatormoden. Unter "eng beeinanderliegende Resonatormoden" werden insbesondere Resonatormoden verstanden, deren Wellenlängenabstand kleiner als 50 nm, vorzugsweise kleiner als 40 nm, noch mehr bevorzugt kleiner als 30 nm und besonders bevorzugt kleiner als 20 nm ist. Aufgrund des Auftretens der ersten und zweiten Resonatormoden als Doppel-Mode bzw. in Form eines Doppel-Dips werden die erste und zweite Resonatormode des Doppelresonators auch als gekoppelte Moden bezeichnet. Ein Einzelresonator dagegen, wie er beispielsweise in der DE 10 2012 007 793 A1 beschrieben ist, weist zwar auch mehrere (longitudinale und transversale) Moden auf, aber keine Doppel-Mode bzw. keinen Doppel-Dip wie es bei einem Doppelresonator der Fall ist. Der spektrale Abstand der Moden ist bei einem Einzelresonator vergleichbarer Größe im Vergleich zum Doppelresonator größer, so dass jeweils nur eine einzige Mode des Einzelresonators verwendet werden kann. Auch wenn der Einzelresonator mehrere diskrete Moden aufweist, so sind diese nicht gekoppelt wie beim Doppelresonator. Ein weiterer Unterschied zwischen einem Einzelresonator und einem Doppelresonator besteht darin, dass beim Doppelresonator mit Hilfe der relativen Positionierung von Spiegeln des Doppelresonators der Wellenlängenabstand der beiden gekoppelten Resonatormoden, d.h. der Resonatormoden des Doppel-Dips, eingestellt werden kann. Insbesondere kann der Wellenlängenabstand der beiden gekoppelten Resonatormoden mit Hilfe der Position des im Folgenden noch näher beschriebenen mittleren bzw. zweiten Spiegels eingestellt werden. Zudem kann die spektrale Position der Doppel-Mode bzw. des Doppel-Dips durch die Position des im Folgenden noch näher beschriebenen oberen bzw. dritten Spiegels eingestellt werden. Die beim Doppelresonator vorhandenen zwei Resonatormoden der Doppel-Mode können insbesondere unabhängig voneinander eingestellt werden. Im Gegensatz zum Einzelresonator können beim Doppelresonator die Spiegel vorteilhafterweise auf wenige Mikrometer (physikalisch) zueinander platziert werden und die Resonanzbedingung kann innerhalb von wenigen 100 nm (physikalisch) eingestellt werden, ohne deutlichen Qualitätsverlust des Resonators. Der erfindungsgemäß verwendete Doppelresonator unterscheidet sich somit grundlegend von einem Einzelresonator, wie er z.B. in der DE 10 2012 007 793 A1 beschrieben ist.

Insbesondere weist der Doppelresonator eine erste einstellbare Resonatormode und eine zweite einstellbare Resonatormode auf. Dies schließt nicht aus, dass der Doppelresonator auch noch weitere Moden aufweisen kann. Die erste Resonatormode ist auf die Wellenlänge bzw. Frequenz der Stimulationslichtquelle bzw. des Stimulationslichts abgestimmt bzw. eingestellt. Mit anderen Worten entspricht die Energie des Stimulationslichts der Energie der ersten Resonatormode. Die Stimulationslichtquelle ist also mit der ersten Resonatormode des Doppelresonators in Resonanz. Die zweite Resonatormode des Doppelresonators ist auf die Wellenlänge bzw. Frequenz des zu erzeugenden Einzelphotons abgestimmt bzw. eingestellt, d.h. die zweite Resonatormode des Doppelresonators ist mit der gewünschten Einzelphotonenemission in Resonanz. Das gewünschte Einzelphoton wird somit in einem spontanen Emissionsprozess in die zweite Resonatormode des Doppelresonators emittiert. Mit anderen Worten ist eine der beiden Eigenresonanzen des Doppelresonators in ihrer Wellenlänge auf die Emissionswellenlänge der Einzelphotonenemission abgestimmt, während die andere der beiden Eigenresonanzen des Doppelresonators in ihrer Wellenlänge auf die Wellenlänge des Stimulationslasers abgestimmt ist. Das aktive Medium ist innerhalb des Doppelresonators angeordnet.

Im Rahmen der vorliegenden Erfindung hat sich herausgestellt, dass bei der bisher vorgeschlagenen technischen Umsetzung einer Einzelphotonenquelle mit Hilfe eines Einzelresonators eine relativ hohe Laserleistung zur Stimulation des Zwei-Photonübergangs und damit zum Erzeugen der Einzelphotonenemission benötigt wird. Insbesondere erkannten die Erfinder, dass dies insbesondere daran liegt, dass zwar der Einzelresonator mit dem zu emittierenden Photon resonant ist, der Einzelresonator aber nicht zugleich auch noch mit dem Stimulationslaser resonant ist. Im Gegensatz zum Stand der Technik beruht die hier vorgestellte technische Lösung nicht auf einem Einzelresonator, sondern auf einer Doppelresonanzmethode bzw. einem Doppelresonator, bei der bzw. dem sowohl die Einzelphotonenemission als auch die Emission der Stimulationslichtquelle auf eine jeweilige Resonanz des Doppelresonators abgestimmt sind. Dadurch kann der Einzelphotonenübergang vorteilhafterweise mit einer sehr viel kleineren Leistung der Stimulationslichtquelle (um ca. den Qualitätsfaktor des Resonators, im Folgenden mit ca. 10.000 angenommen) gesteuert werden. Dies hat zur Folge, dass auch das Streulicht der Stimulationslichtquelle um diesen Faktor reduziert wird, und dass das hier beschriebene theoretische Konzept zur Einzelphotonenerzeugung sehr viel einfacher, wenn nicht erst überhaupt, technisch umsetzbar wird.

In einer bevorzugten Ausführungsform umfasst der Doppelresonator drei Spiegel. Mit Hilfe von drei hintereinander angeordneter Spiegeln lassen sich in besonders einfacher Weise zwei gekoppelte Resonatormoden realisieren.

In einer weiteren bevorzugten Ausführungsform sind die Spiegel derart angeordnet, dass zwischen einem ersten Spiegel (unterer Spiegel) und einem zweiten Spiegel (mittlerer Spiegel) eine erste Kavität ausgebildet ist und zwischen dem zweiten und einem dritten Spiegel (oberer Spiegel) eine zweite Kavität ausgebildet ist. Unter einer Kavität wird insbesondere ein Raum zwischen zwei Spiegeln des Doppelresonators verstanden.

In einer weiteren bevorzugten Ausführungsform ist zumindest einer der drei Spiegel, vorzugsweise der dritte bzw. obere Spiegel, verschiebbar. Dies kann z.B. mit Hilfe von Verstellelementen und/oder einem Piezo-Aktuator realisiert werden. Durch ein Verschieben zumindest eines der Spiegel bzw. durch ein Verschieben der Spiegel relativ zueinander kann eine optische Länge des Doppelresonators und damit die Eigenresonanzfrequenzen bzw. die Resonatormoden des Doppelresonators eingestellt werden.

In einer weiteren bevorzugten Ausführungsform sind der erste Spiegel, das aktive Medium und der zweite Spiegel einstückig ausgebildet, d.h. monolithisch integriert. Ferner ist der dritte Spiegel, insbesondere mit Hilfe von Verstellelementen bzw. einem Piezo-Aktuator, verschiebbar. Es hat sich herausgestellt, dass damit in besonders effektiver und einfacher Weise die Resonatorlänge des Doppelresonators beliebig eingestellt werden kann. Auf diese Weise kann die variable Einstellung der beiden Resonanzen bzw. Resonatormoden des Doppelresonators möglichst effektiv vorgenommen werden. Die einstückige Ausbildung der beiden ersten Spiegel und des aktiven Mediums ermöglichen einerseits eine kompakte Bauweise und gewährleisten andererseits eine zuverlässige und reproduzierbare Einstellung der gewünschten Resonatormoden mit Hilfe des dritten Spiegels.

In einer weiteren bevorzugten Ausführungsform ist das aktive Medium in der ersten Kavität, d.h. zwischen dem ersten und zweiten Spiegel, oder in der zweiten Kavität, d.h. zwischen dem zweiten und dritten Spiegel, angeordnet. Sofern, wie es in der Regel der Fall ist, die Qualität, insbesondere die Oberflächenqualität, des zweiten Spiegels besser ist als die des dritten Spiegels, kann eine Anordnung des aktiven Mediums in der ersten Kavität von besonderem Vorteil sein.

In einer weiteren bevorzugten Ausführungsform sind die drei Spiegel als Bragg-Spiegel (DBR = "Distributed Bragg Reflector") ausgebildet. Vorzugsweise werden dafür AlAs/GaAs DBR Strukturen verwendet.

In einer weiteren bevorzugten Ausführungsform weist die Vorrichtung ferner eine optische Faser, insbesondere Glasfaser, auf, welche ausgelegt ist, um das erzeugte Einzelphoton zu transportieren bzw. aus dem Doppelresonator auszukoppeln. Dabei ist der dritte Spiegel, insbesondere ein Bragg-Spiegel, in der optischen Faser integriert. Insbesondere ist der dritte Spiegel in Form eines konkaven Endabschnitts der optischen Faser ausgebildet. Der konkave Endabschnitt ist vorzugsweise mit einer dielektrischen Schicht beschichtet, was dem Endabschnitt eine bestimmte bzw. vordefinierte Reflektivität $R_3$ verleiht. Der dritte Spiegel wird im Sinne dieser Beschreibung daher auch als Faser-Spiegel bezeichnet werden. Dieser Faser-Spiegel hat den vorteilhaften technischen Effekt, dass er gleichzeitig zum Einstellen der Resonatorlänge, und damit auch der beiden Resonatormoden, des Doppelresonantors sowie zum Auskoppeln der erzeugten Einzelphotonen dient. Eine besonders kompakte und effektive Bauweise der Einzelphotonenquelle ist dadurch möglich.

In einer weiteren bevorzugten Ausführungsform ist der dritte Spiegel in eine für die Einzelphotonenemission transparente Schicht implementiert. Dabei weist die Vorrichtung eine optische Faser, insbesondere Glasfaser, auf, welche ausgelegt ist, um das erzeugte Einzelphoton zu transportieren bzw. aus dem Doppelresonator auszukoppeln. Ferner weist die Vorrichtung in dieser Ausführungsform eine Linse auf, welche ausgelegt und angeordnet ist, um das erzeugte Einzelphoton in die optische Faser einzukoppeln.

In einer weiteren bevorzugten Ausführungsform gilt für die Reflektivität $R_1$ des ersten Spiegels, die Reflektivität $R_2$ des zweiten Spiegels und die Reflektivität $R_3$ des dritten Spiegels folgender Zusammenhang: $R_1 > R_3 > R_2$. Vorzugsweise gilt: $R_1 > R_3 >> R_2$. Im Rahmen der vorliegenden Erfindung hat sich herausgestellt, dass unter diesen Bedingungen ein für die Einzelphotonenquelle geeigneter Doppelresonator mit zwei einstellbaren bzw. abstimmbaren Resonatormoden verwirklicht werden kann. Insbesondere hat sich herausgestellt, dass der dritte Spiegel, über den ausgekoppelt wird, eine niedrigere Reflektivität haben muss als der gegenüberliegende erste Spiegel. Weiterhin darf der zweite Spiegel keine höhere Reflektivität als der erste Spiegel haben, da sonst nur eine Einfach-Cavity bzw. ein Einzelresonator zwischen dem dritten Spiegel und dem zweiten Spiegel zustande kommen würde. Eine weitere Ausführungsform wäre, die Reflektivitäten des dritten und ersten Spiegels zu vertauschen, so dass gilt: $R_3 > R_1 > R_2$. Hierbei würde das System dann die Photonen nach unten über den ersten Spiegel abstrahlen, und die Photonen müssten, z.B. mit einer weiteren Faser oder freistrahlend, aufgesammelt werden.

In einer weiteren bevorzugten Ausführungsform umfasst bzw. ist die Anregungsquelle eine Anregungslichtquelle. Die Anregungslichtquelle ist ausgelegt und angeordnet, um das aktive Medium mit Anregungslicht zu bestrahlen und somit das Biexziton ($|XX\rangle$) zu erzeugen. Die Anregungslichtquelle und die Stimulationslichtquelle sind vorzugsweise derart angeordnet, dass die Strahlrichtung bzw. eine optische Achse der Anregungslichtquelle und die Emissionsrichtung des emittierten Einzelphotons orthogonal zueinander sind. Diese Konfiguration hat den Vorteil, dass der Anregungslaser und die emittierten bzw. detektierten Photonen geometrisch voneinander getrennt sind. Dies bewirkt weniger Streulicht im System. Insbesondere bei spektral breiten Lasern ist es damit möglich, bereits geometrisch zu filtern, ohne eine Polarisationsunterdrückung (Trennung von Anregungslaser und detektierten Photonen, insbesondere wenn deren Wellenlängen nah beieinander liegen) in die Anordnung zu implementieren. Die Strahlrichtung des Stimulationslasers und die Strahlrichtung des erzeugten Einzelphotons sind insbesondere antiparallel zueinander und in Richtung einer Achse, insbesondere in Richtung der optischen Achse, des Doppelresonators ausgerichtet. Das Anregungslicht kann mit Hilfe eines freistehenden Anregungslasers direkt auf das aktive Medium eingestrahlt werden. Alternativ kann das Anregungslicht mit Hilfe einer optischen Faser zu dem aktiven Medium geleitet werden, wobei ein Ende bzw. Endabschnitt der optischen Faser an dem aktiven Medium angeordnet und vorzugsweise auf das aktive Medium aufgeklebt ist. Vorzugsweise ist eine optische Achse der Anregungslichtquelle orthogonal zu einer optischen Achse der Stimulationslichtquelle orientiert.

Die Anregungsquelle kann alternativ oder zusätzlich eine Spannungsquelle umfassen bzw. sein. Mit Hilfe der Spannungsquelle kann die Anregung des Biexzitons elektrisch, insbesondere durch Anlegen von Spannungspulsen an das aktive Medium, erfolgen.

In einer weiteren bevorzugten Ausführungsform ist die Wellenlänge des emittierten Einzelphotons durch die Wellenlänge des Stimulationslichts bestimmt. Alternativ oder zusätzlich ist die Polarisation des emittierten Einzelphotons durch die Polarisation des Stimulationslichts bestimmt. Alternativ oder zusätzlich sendet die Stimulationslichtquelle gepulstes Stimulationslicht aus, wobei der zeitliche Verlauf der Wellenform und damit auch die Pulsbreite des emittierten Einzelphotons durch den zeitlichen Verlauf der Pulsform bzw. der Pulsbreite des Stimulationslichts bestimmt ist.

Ein weiterer unabhängiger Aspekt zur Lösung der Aufgabe betrifft ein Verfahren zur Erzeugung einer Einzelphotonenemission, umfassend die Schritte:

- Bereitstellen eines zu einem Biexziton-Zustand anregbaren Systems, insbesondere ein aktives Medium mit Quantenpunkten;
- Erzeugen eines Biexzitons durch Anregen des Systems;
- Erzeugen eines virtuellen Zustands auf Basis des erzeugten Biexzitons durch Bestrahlen des Systems mit Stimulationslicht, wobei der virtuelle Zustand ein Zustand ist, aus dem ein Einzelphoton spontan emittiert wird.

Das zu einem Biexziton-Zustand anregbare System bzw. das aktive Medium wird in einer Doppelresonatorstruktur bzw. einem Doppelresonator, welche/welcher zwei einstellbare Resonatormoden aufweist, bereitgestellt. Dabei wird eine erste der beiden Resonatormoden auf eine gewünschte Wellenlänge der Einzelphotonenemission (d.h. des zu emittierenden Einzelphotons) eingestellt und eine zweite der beiden Resonatormoden auf die Wellenlänge des Stimulationslichts eingestellt.

In einer bevorzugten Ausführungsform erfolgt das Einstellen der Resonatormoden durch Verschieben zumindest eines Spiegels der Doppelresonatorstruktur.

In einer weiteren bevorzugten Ausführungsform werden optische Eigenschaften, insbesondere die Wellenlänge, die Polarisation und die Pulsform bzw. Pulsbreite, des Stimulationslichts in Abhängigkeit der gewünschten optischen Eigenschaften, insbesondere der Wellenlänge, der Polarisation und der Pulsform bzw. Pulsbreite, der Einzelphotonenemission gewählt.

Für den oben genannten weiteren unabhängigen Aspekt und insbesondere für diesbezügliche bevorzugte Ausführungsformen gelten auch die vor- oder nachstehend gemachten Ausführungen zu den Ausführungsformen des ersten Aspekts. Insbesondere gelten für einen unabhängigen Aspekt der vorliegenden Erfindung und für diesbezügliche bevorzugte Ausführungsformen auch die vor- und nachstehend gemachten Ausführungen zu den Ausführungsformen des jeweils anderen unabhängigen Aspekts.

Im Folgenden werden einzelne Ausführungsformen zur Lösung der Aufgabe anhand der Figuren beispielhaft beschrieben. Dabei weisen die einzelnen beschriebenen Ausführungsformen zum Teil Merkmale auf, die nicht zwingend erforderlich sind, um den beanspruchten Gegenstand auszuführen, die aber in bestimmten Anwendungsfällen gewünschte Eigenschaften bereitstellen. So sollen auch Ausführungsformen als unter die beschriebene technische Lehre fallend offenbart angesehen werden, die nicht alle Merkmale der im Folgenden beschriebenen Ausführungsformen aufweisen. Ferner werden, um unnötige Wiederholungen zu vermeiden, bestimmte Merkmale nur in Bezug auf einzelne der im Folgenden beschriebenen Ausführungsformen erwähnt. Es wird darauf hingewiesen, dass die einzelnen Ausführungsformen daher nicht nur für sich genommen, sondern auch in einer Zusammenschau betrachtet werden sollen. Anhand dieser Zusammenschau wird der Fachmann erkennen, dass einzelne Ausführungsformen auch durch Einbeziehung von einzelnen oder mehreren Merkmalen anderer Ausführungsformen modifiziert werden können. Es wird darauf hingewiesen, dass eine systematische Kombination der einzelnen Ausführungsformen mit einzelnen oder mehreren Merkmalen, die in Bezug auf andere Ausführungsformen beschrieben werden, wünschenswert und sinnvoll sein kann und daher in Erwägung gezogen und auch als von der Beschreibung umfasst angesehen werden soll.

Kurze Beschreibung der Zeichnungen

Figur 1    zeigt eine schematische Skizze des für die vorliegende Erfindung verwendeten Konzepts der Einzelphotonenerzeugung;

Figur 2    zeigt eine schematische Skizze einer Vorrichtung zur Erzeugung einer Einzelphotonenemission gemäß einer bevorzugten Ausführungsform der vorliegenden Erfindung;

Figur 3    zeigt eine schematische Skizze einer Vorrichtung zur Erzeugung einer Einzelphotonenemission gemäß einer weiteren bevorzugten Ausführungsform der vorliegenden Erfindung;

Figur 4    zeigt eine schematische Skizze einer Vorrichtung zur Erzeugung einer Einzelphotonenemission gemäß einer weiteren bevorzugten Ausführungsform der vorliegenden Erfindung;

Figur 5    zeigt ein beispielhaftes simuliertes Reflektivitätsspektrum eines Doppelresonators.

## Detaillierte Beschreibung der Zeichnungen

Die in der vorliegenden Beschreibung gewählten Lageangaben, wie z. B. oben, unten, seitlich usw. sind jeweils auf die unmittelbar beschriebene sowie dargestellte Figur bezogen und sind bei einer Lageänderung sinngemäß auf die neue Lage zu übertragen.

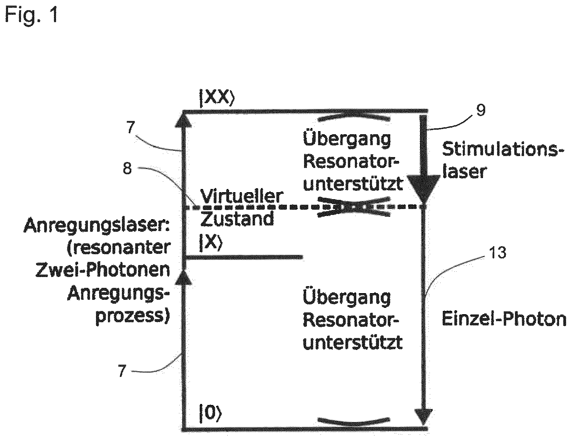

Die **Figur 1** zeigt eine schematische Skizze des für die vorliegende Erfindung verwendeten Konzepts der Einzelphotonenerzeugung durch einen Zwei-Photonen-Übergang von einem Quantenpunkt-Biexziton $|XX\rangle$. Das Biexziton $|XX\rangle$ im Quantenpunkt wird durch einen Zwei-Photonen-Absorptionsprozess im Quantenpunkt erzeugt (angedeutet durch die Pfeile nach oben auf der linken Seite der Skizze). Dieser Zwei-Photonen-Absorptionsprozess umfasst, ausgehend vom Grundzustand $|0\rangle$, die direkte Anregung eines Biexzitons $|XX\rangle$. Die Energie bzw. Wellenlänge des Anregungslichts 7 entspricht also der halben Energiedifferenz zwischen dem Zustand des Biexzitons $|XX\rangle$ und dem Grundzustand $|0\rangle$. Ausgehend vom erzeugten Biexziton $|XX\rangle$ wird schließlich die Emission eines dritten Photons in einen virtuellen Zustand 8 durch ein von einem Stimulationslaser ausgesandten Stimulationslicht 9, das erfindungsgemäß resonant mit einer Resonatormode eines erfindungsgemäß verwendeten Doppelresonators (in der Figur 1 nicht gezeigt) ist, in einem stimulierten Emissionsprozess ausgelöst. Ein viertes Photon, nämlich das gewünschte Einzelphoton 13, wird in einem spontanen Emissionsprozess in die zweite Resonatormode des erfindungsgemäßen Doppelresonators emittiert.

Durch eine Einflußnahme auf den Zerfallskanal des erzeugten Biexzitons $|XX\rangle$ kann also gezielt ein Photon 13 durch spontane Emission erzeugt werden, das gewünschte bzw. deterministisch einstellbare Eigenschaften hinsichtlich Wellenlänge, Polarisation und Pulsform hat. Eine solche Einflußnahme kann insbesondere dadurch vorgenommen werden, dass durch Bestrahlung des Systems mit Stimulationslicht 9 der virtuelle Zustand 8 des Systems erzeugt wird, von dem aus die Emission eines Photons in den Grundzustand $|0\rangle$ möglich wird. Hierfür kann der Übergang zwischen dem Biexziton $|XX\rangle$ und dem virtuellen Zustand 8 durch eine geeignet gewählte Intensität des Stimulationslichts 9 bzw. Stimulationslasers gesättigt werden. Durch die Einstrahlung bzw. Beleuchtung des Systems mit dem Stimulationslicht 9 kann der Zerfallskanal des Biexzitons $|XX\rangle$ vorbestimmt werden, so dass sich aus dieser Vorbestimmung deterministisch die Eigenschaften des weiteren im Zerfallskanal vorgesehenen einzelnen Photons 13 ergeben.

Die Energie und damit die Wellenlänge des spontan emittierten Einzelphotons 13 ist gegeben durch die Energie des Biexzitons $|XX\rangle$ abzüglich der Energie des Stimulationslichts 9 mit dem der virtuelle Zustand 8 erzeugt wird. Es kann also durch Auswahl der Wellenlänge des Stimulationslichts 9 zur Erzeugung des virtuellen Zustandes 8 die Wellenlänge des erzeugten Einzelphotons 13 eingestellt werden.

Ferner ist die Polarisation des emittierten Photons 13 komplementär zu der Polarisation des Stimulationslichts 9 das zur Erzeugung des virtuellen Zustandes 8 eingesetzt wird, da die beteiligten Endniveaus (Biexziton $|XX\rangle$ und Grundzustand $|0\rangle$) jeweils Spin NULL aufweisen. Somit kann durch Auswahl der Polarisation des Stimulationslichts 9 zur Erzeugung des virtuellen Zustandes 8 die Polarisation des erzeugten Einzelphotons 13 eingestellt werden.

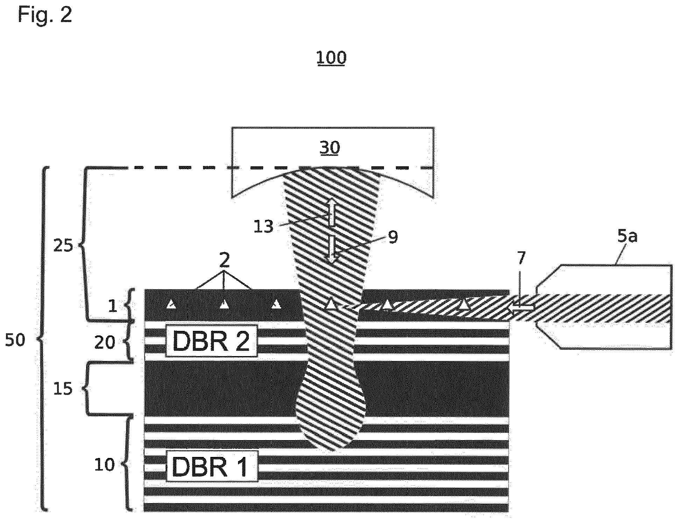

Die **Figur 2** zeigt eine schematische Skizze einer Vorrichtung 100 zur Erzeugung einer Einzelphotonenemission gemäß einer bevorzugten Ausführungsform der vorliegenden Erfindung. Die Vorrichtung 100 weist ein aktives Medium 1 auf, welches in einer Doppelresonatorstruktur bzw. einem Doppelresonator 50 angeordnet ist und zu einem Biexziton-Zustand anregbare Quantenpunkte 2 aufweist. Mit einer Anregungslichtquelle 5a wird das aktive Medium 1 mit Anregungslicht 7 bestrahlt bzw. beleuchtet und somit ein Biexziton $|XX\rangle$ erzeugt (siehe Figur 1). Mit einer Stimulationslichtquelle (in der Figur 2 nicht explizit gezeigt), dessen optische Achse parallel zur optischen Achse des Doppelresonators 50 ausgerichtet ist, wird das aktive Medium 1 mit Stimulationslicht 9 bestrahlt bzw. beleuchtet und somit auf Basis des erzeugten Biexzitons $|XX\rangle$ durch stimulierte Emission eines Photons ein virtueller Zustand 8 erzeugt (siehe Figur 1). Das Stimulationslicht 9 wird vorzugsweise über die optische Faser 30 in den Doppelresonator 50 eingekoppelt. Die optische Faser 30 ist somit vorzugsweise ausgelegt, das Stimulationslicht 9 in den Doppelresonator 50 einzukoppeln und die von der Einzelphotonenquelle 100 erzeugten Photonen 13 aus dem Doppelresonator 50 auszukoppeln. Die optische Achse des Anregungslasers 5a kann parallel zur optischen Achse des Stimulationslasers ausgerichtet sein. Vorzugsweise ist die optische Achse des Anregungslasers 5a aber orthogonal zur optischen Achse des Stimulationslasers ausgerichtet. Mit einer solchen Anordnung, in der das Anregungslicht 7 und das Stimulationslicht 9 orthogonal zueinander emittiert werden, kann Streulicht möglichst effektiv unterdrückt werden kann.

Der Doppelresonator 50 weist einen ersten Bragg-Spiegel 10 (DBR 1) und einen zweiten Bragg-Spiegel 20 (DBR 2) auf. Zwischen dem ersten Bragg-Spiegel 10 und dem zweiten Bragg-Spiegel 20 ist eine erste Kavität 15 ausgebildet. Ferner weist der Doppelresonator 50 einen Faserspiegel 30 auf, welcher in Form eines konkaven Endabschnitts einer optischen Faser ausgebildet ist. Zwischen dem zweiten Bragg-Spiegel 20 und dem Faserspiegel 30 ist eine zweite Kavität 25 ausgebildet. Das aktive Medium 1 ist in dieser zweiten Kavität 25, also zwischen dem zweiten Bragg-Spiegel 20 und dem Faserspiegel 30, angeordnet. Der Faserspiegel 30 kann insbesondere einen Bragg-Spiegel in der optischen Faser darstellen.

Im Ausführungsbeispiel der Figur 2 wird das Anregungslicht 7 mit Hilfe eines freistehenden Anregungslasers 5a direkt auf das aktive Medium 1 eingestrahlt.

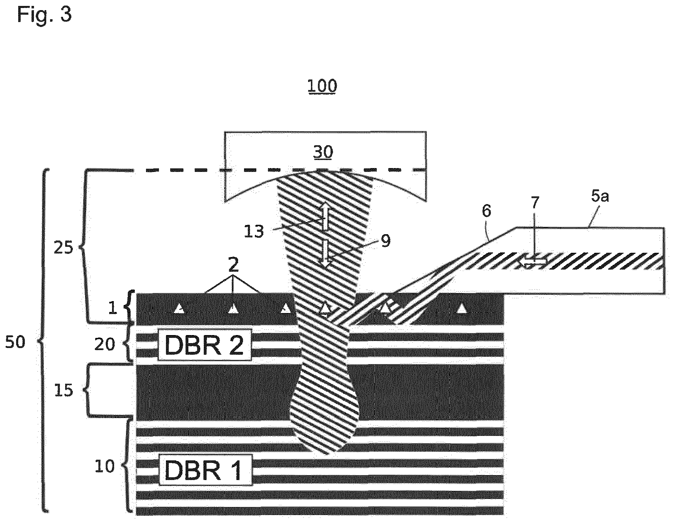

Alternativ kann, wie in der **Figur 3** dargestellt, das Anregungslicht 7 mit Hilfe einer optischen Faser 6, zu dem aktiven Medium 1 geleitet werden, wobei ein Ende bzw. Endabschnitt der optischen Faser an dem aktiven Medium 1 angeordnet und bzw. auf das aktive Medium 1 aufgeklebt ist. Die in der Figur 3 dargestellten Elemente entsprechen ansonsten den mit gleichen Bezugszeichen versehenen Elementen in der Figur 2.

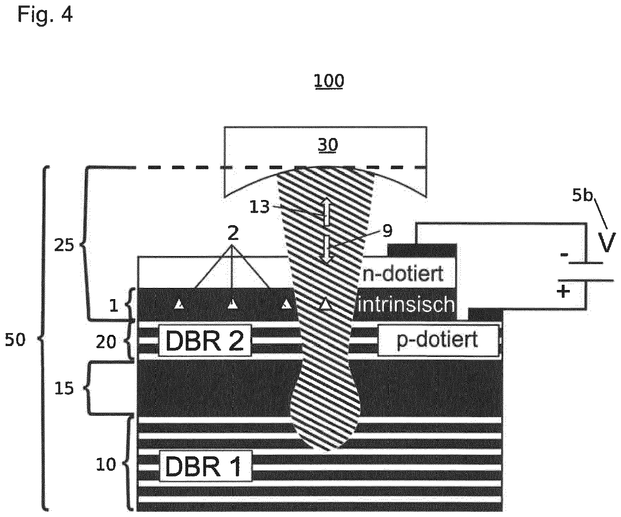

Die **Figur 4** zeigt eine schematische Skizze einer Vorrichtung 100 zur Erzeugung einer Einzelphotonenemission gemäß einer weiteren Ausführungsform der vorliegenden Erfindung. In dieser Ausführungsform wird das Biexziton elektrisch angeregt, indem das aktive Medium 1 bzw. die Quantenpunkte 2 mit kurzen Spannungspulsen elektrisch getrieben werden. Die Einzelphotonenquelle 100 weist somit in dieser Ausführungsform eine Spannungsquelle 5b auf. Das aktive Medium 1 bzw. die Quantenpunkte 2 sind als pin-Struktur, also einer Struktur mit einem p-dotierten Bereich, einem intrinsischen Bereich und einem n-dotierten Bereich, ausgebildet. Die Spannungsquelle ist mit dem n-dotierten Bereich und mit dem p-dotierten Bereich verbunden. Insbesondere ist der Minuspol der Spannungsquelle mit dem n-dotierten Bereich und der Pluspol der Spannungsquelle mit dem p-dotierten Bereich verbunden. Da die Anregung in der Ausführungsform von Figur 4 elektrisch erfolgt, kann vorteilhafterweise auf eine Anregungslichtquelle verzichtet werden. Die in der Figur 4 dargestellten Elemente entsprechen ansonsten den mit gleichen Bezugszeichen versehenen Elementen in den Figuren 2 und 3.

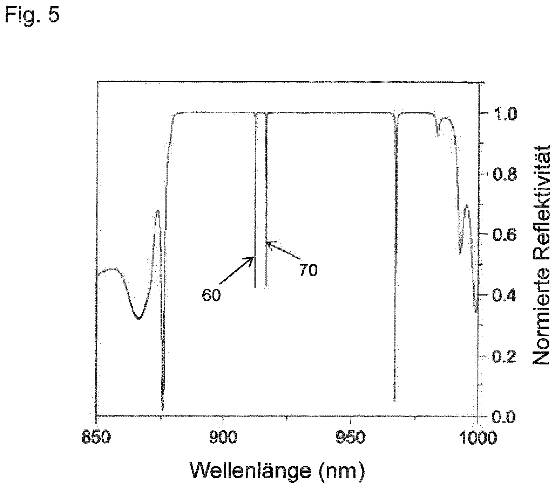

Die **Figur 5** zeigt ein beispielhaftes simuliertes Reflektivitätsspektrum eines zu der vorliegenden Erfindung einsetzbaren Doppelresonators 50. Das Diagramm der Figur 5 stellt eine simulierte normierte Reflektivität eines beispielhaften Doppelresonators 50 in Abhängigkeit von der Wellenlänge des durch den Doppelresonator 50 hindurchtretenden Lichts dar. Dabei ist ersichtlich, dass der Doppelresonator 50 eine erste Resonatormode 60 und eine zweite Resonatormode 70 aufweist, die in Form einer Doppel-Mode bzw. eines Doppel-Dips auftreten. Dadurch unterscheidet sich der Doppelresonator 50 von einem Einzelresonator, welcher im Vergleich zum Doppelresonator 50 keine Moden in Form eines Doppel-Dips, sondern lediglich weiter auseinanderliegende diskrete Moden aufweist. In Abgrenzung zu den diskreten Moden eines Einzelresonators werden im Rahmen dieser Beschreibung die Resonatormoden 60 und 70 des Doppelresonators 50 als gekoppelte Moden bezeichnet. Ein Einzelresonator weist keine solchen gekoppelten Moden auf. Die erste Resonatormode 60 des Doppelresonators 50 kann z.B. auf die Wellenlänge der Stimulationslichtquelle abgestimmt sein. Die zweite Resonatormode 70 des Doppelresonators 50 kann z.B. auf die gewünschte Wellenlänge des zu emittierenden Einzelphotons 13 abgestimmt sein. Die beiden Resonatormoden 60 und 70 können durch Variieren der Resonatorlänge, insbesondere durch Verschieben eines der Spiegel des Doppelresonators 50, eingestellt werden. Insbesondere wird der Abstand zwischen den Dips durch die Position des mittleren bzw. zweiten Spiegels 20 eingestellt, während die spektrale Position des Doppel-Dips durch den oberen bzw. dritten Spiegel 30 eingestellt wird. Damit kann auch die Wellenlänge der erzeugten Einzelphotonenemission festgelegt bzw. eingestellt werden.

Zusammenfassend kann festgehalten werden, dass die erfindungsgemäße Einzelphotonenquelle 100 mit einer Doppelresonatorstruktur aufgebaut ist, bei welcher der Resonator 50 in seiner Länge variiert und abgestimmt werden kann. Dadurch können die beiden Eigenresonanzen des Doppelresonators 50 in ihrer Wellenlänge auf die Emissionswellenlänge der Einzelphotonenemission und des Stimulationslasers abgestimmt werden. In der Folge kann der Einzelphotonenübergang mit einer sehr viel kleineren Leistung des Stimulationslasers (um ca. den Qualitätsfaktor des Doppelresonators, der z.B. ca. 10.000 betragen kann) gesteuert werden. Dies hat wiederum zur Folge, dass das Streulicht des Stimulationslasers um diesen Faktor reduziert wird, und dass das dieser Erfindung zu Grunde liegende Konzept sehr viel einfacher, wenn nicht überhaupt erst technisch umsetzbar wird. Die hohe Brillanz der Einzelphotonenquelle 100 wird durch die Einkopplung der Einzelphotonenemission in eine Resonatormode und einer anschließenden effizienten Sammlung der Photonen 13 mittels Glasfaser ermöglicht. Hierbei kann der obere Bragg-Spiegel 30 direkt in die Glasfaser integriert werden oder sehr flexibel in eine für die Einzelphotonenemission transparente Schicht implementiert werden. Im letzteren Fall wird das von der Einzelphotonenquelle emittierte Licht 13 anschließend mit Hilfe einer Linse (in den Figuren nicht gezeigt) in die Glasfaser eingekoppelt.

Mit der vorliegenden Erfindung kann insbesondere eine gepulste Einzelphotonenquelle 100 mit hoher Brillanz, die ununterscheidbare Photonen emittiert, und bei der gleichzeitig die Emissionswellenlänge, die Pulsbreite und die Polarisation der emittierten Photonen 13 eingestellt werden können. Die oberflächenemittierende Einzelphotonenquelle 100 weist eine modulare und von aussen einstellbare Doppelresonatorstruktur auf, die eine hohe Flexibilität und damit eine Verbesserung bei der gleichzeitigen Einstellung der Wellenlänge, Pulsbreite und Polarisation der Einzelphotonenemission zulässt.

Eine abstimmbare Doppelresonatorstruktur 50 mit aktiver Quantenpunktschicht 1, ein abstimmbarer Stimulationslaser und eine um 90° zur optischen Achse des Doppelresonators bzw. zur optischen Achse des Stimulationslasers orientierte Pump- bzw. Anregungslaservorrichtung erfüllen somit die dieser Erfindung zu Grunde liegende und eingangs erwähnte Aufgabe. Durch die freie Wahl z.B. der Pulsbreite können insbesondere kürzere Einzelphotonenpulse (im Bereich von 10 ps) als bei herkömmlichen Realisierungen erreicht werden. Die so erzeugten Photonen besitzen zudem einen hohen Kohärenzgrad, da sie nicht so anfällig gegenüber typischen kohärenzzerstörenden Prozessen sind, die typischerweise auf einer längeren Zeitskala (ca. 100 ps bis 1 ms) stattfinden, und dadurch können ununterscheidbare Photonen erzeugt werden. Daher können diese Quellen für vielfältige Anwendungen im Bereich der Quanteninformationstechnologien eingesetzt werden. Hierzu gehören Anwendungen im Bereich des Quanten-Repeaters, der Quantensimulation, des Quantenrechnens, usw.

**Bezugszeichenliste**

| | |
|---|---|
| 1 | aktives Medium |
| 2 | Quantenpunkt |
| 5 | Anregungsquelle |
| 5a | Anregungslichtquelle bzw. Anregungslaser |
| 5b | Spannungsquelle |
| 6 | optische Faser |
| 7 | Anregungslicht |
| 8 | virtueller Zustand |
| 9 | Stimulationslicht |
| 10 | erster Spiegel (Bragg-Spiegel) |
| 15 | erste Kavität |
| 20 | zweiter Spiegel (Bragg-Spiegel) |
| 25 | zweite Kavität |
| 30 | dritter Spiegel (Bragg-Spiegel bzw. Faserspiegel) |
| 50 | Doppelresonatorstruktur bzw. Doppelresonator |
| 60 | erste Resonatormode |
| 70 | zweite Resonatormode |
| 100 | Einzelphotonenquelle |

**Patentansprüche**

1. Vorrichtung (100) zum Erzeugen eines Einzelphotons (13), aufweisend:

   - ein zu einem Biexziton-Zustand anregbares aktives Medium (1);
   - eine Anregungsquelle (5a; 5b), welche ausgelegt ist, um auf Basis des aktiven Mediums (1) ein Biexziton ($|XX\rangle$) zu erzeugen;
   - eine Stimulationslichtquelle, welche ausgelegt und angeordnet ist, um das aktive Medium (1) mit Stimulationslicht (9) zu bestrahlen und somit auf Basis des erzeugten Biexzitons ($|XX\rangle$) einen virtuellen Zustand (8) zu erzeugen, aus dem heraus das Einzelphoton (13) emittierbar ist;

   wobei die Vorrichtung ferner einen Doppelresonator (50) aufweist, in dem das aktive Medium (1) angeordnet ist, wobei der Doppelresonator (50) zwei gekoppelte Resonatormoden (60, 70) aufweist, wobei die erste Resonatormode (60) auf eine Wellenlänge der Stimulationslichtquelle abgestimmt ist und wobei die zweite Resonatormode (70) auf eine gewünschte Wellenlänge des emittierten Einzelphotons (13) abgestimmt ist.

2. Vorrichtung (100) nach Anspruch 1, wobei der Doppelresonator (50) drei Spiegel (10, 20, 30) umfasst.

3. Vorrichtung (100) nach Anspruch 2, wobei die Spiegel (10, 20, 30) derart angeordnet sind, dass zwischen einem ersten Spiegel (10) und einem zweiten Spiegel (20) eine erste Kavität (15) ausgebildet ist und zwischen dem zweiten Spiegel (20) und einem dritten Spiegel (30) eine zweite Kavität (25) ausgebildet ist.

4. Vorrichtung (100) nach Anspruch 2 oder 3, wobei zumindest einer der drei Spiegel (10, 20, 30) verschiebbar ist.

5. Vorrichtung (100) nach Anspruch 3 oder 4, wobei der erste Spiegel (10), das aktive Medium (1) und der zweite Spiegel (20) einstückig ausgebildet sind, und wobei der dritte Spiegel (30) verschiebbar ist.

6. Vorrichtung (100) nach einem der Ansprüche 3 bis 5, wobei das aktive Medium (1) in der ersten Kavität (15) oder in der zweiten Kavität (25) angeordnet ist.

7. Vorrichtung (100) nach einem der Ansprüche 3 bis 6, wobei die drei Spiegel (10, 20, 30) als Bragg-Spiegel ausgebildet sind.

8. Vorrichtung (100) nach einem der Ansprüche 3 bis 7, ferner aufweisend:

   - eine optische Faser, welche ausgelegt ist, um das erzeugte Einzelphoton (13) zu transportieren, wobei der dritte Spiegel (30) in der optischen Faser integriert ist und/oder in Form eines konkaven und beschichteten Endabschnitts der optischen Faser ausgebildet ist.

9. Vorrichtung (100) nach einem der Ansprüche 3 bis 7, wobei
   der dritte Spiegel (30) in eine für die Einzelphotonenemission transparente Schicht implementiert ist, und wobei die Vorrichtung (100) ferner aufweist:

   - eine optische Faser, welche ausgelegt ist, um das erzeugte Einzelphoton (13) zu transportieren;
   - eine Linse, welche ausgelegt und angeordnet ist, um das erzeugte Einzelphoton (13) in die optische Faser einzukoppeln.

10. Vorrichtung (100) nach einem der Ansprüche 3 bis 9, wobei für die Reflektivität $R_1$ des ersten Spiegels

(10), die Reflektivität $R_2$ des zweiten Spiegels (20) und die Reflektivität $R_3$ des dritten Spiegels (30) gilt:

$$R_1 > R_3 > R_2 \text{ oder } R_3 > R_1 > R_2.$$

11. Vorrichtung (100) nach einem der vorangehenden Ansprüche,

    wobei die Anregungsquelle (5a; 5b) eine Anregungslichtquelle (5a) umfasst, welche ausgelegt und angeordnet ist, um das aktive Medium (1) mit Anregungslicht (7) zu bestrahlen und somit das Biexziton ($|XX\rangle$) zu erzeugen, wobei die Anregungslichtquelle (5a) und die Stimulationslichtquelle vorzugsweise derart angeordnet sind, dass die Strahlrichtung der Anregungslichtquelle (5a) und die Emissionsrichtung des emittierten Einzelphotons (13) orthogonal zueinander sind; und/oder

    wobei die Anregungsquelle (5a; 5b) eine Spannungsquelle (5b) umfasst.

12. Vorrichtung (100) nach einem der vorangehenden Ansprüche,

    wobei die Wellenlänge des emittierten Einzelphotons (13) durch die Wellenlänge des Stimulationslichts (9) bestimmt ist, und/oder

    wobei die Polarisation des emittierten Einzelphotons (13) durch die Polarisation des Stimulationslichts (9) bestimmt ist, und/oder

    wobei die Stimulationslichtquelle gepulstes Stimulationslicht (9) aussendet und der zeitliche Verlauf der Wellenform des emittierten Einzelphotons (13) durch den zeitlichen Verlauf der Pulsform des Stimulationslichts (9) bestimmt ist.

13. Verfahren zur Erzeugung einer Einzelphotonenemission, umfassend die Schritte:

    - Bereitstellen eines zu einem Biexziton-Zustand anregbaren Systems (1);
    - Erzeugen eines Biexzitons ($|XX\rangle$) durch Anregen des Systems (1);
    - Erzeugen eines virtuellen Zustands (8) auf Basis des erzeugten Biexzitons ($|XX\rangle$) durch Bestrahlen des Systems (1) mit Stimulationslicht (9), wobei der virtuelle Zustand (8) ein Zustand ist, aus dem ein Einzelphoton (13) spontan emittiert wird;

    wobei das zu einem Biexziton-Zustand anregbare System in einer Doppelresonatorstruktur (50), welche zwei einstellbare Resonatormoden (60, 70) aufweist, bereitgestellt wird, wobei eine Resonatormode (60) auf eine gewünschte Wellenlänge der Einzelphotonenemission eingestellt wird und wobei eine zweite Resonatormode (70) auf die Wellenlänge des Stimulationslichts (9) eingestellt wird.

14. Verfahren nach Anspruch 13, wobei das Einstellen der Resonatormoden (60, 70) durch Verschieben zumindest eines Spiegels der Doppelresonatorstruktur (50) erfolgt.

15. Verfahren nach Anspruch 13 oder 14, wobei die Wellenlänge, die Polarisation und/oder die Pulsform des Stimulationslichts (9) in Abhängigkeit der gewünschten Wellenlänge, Polarisation und/oder Pulsform der Einzelphotonenemission gewählt werden.

**Claims**

1. A device (100) for generating a single photon (13), comprising:

    - an active medium (1), which can be excited into a biexciton state;
    - an excitation source (5a; 5b), which is designed to produce a biexciton ($|XX\rangle$) on the basis of the active medium (1);
    - a stimulation light source, which is designed and arranged to irradiate the active medium (1) with stimulation light (9) and, on the basis of the produced biexciton ($|XX\rangle$), to thus produce a virtual state (8) from which the single photon (13) can be emitted;

    wherein the device further comprises a double resonator (50), in which the active medium (1) is arranged, wherein the double resonator (50) comprises two coupled resonator modes (60, 70), wherein the first resonator mode (60) is tuned to a wavelength of the stimulation light source and wherein the second resonator mode (70) is tuned to a desired wavelength of the emitted single photon (13).

2. The device (100) according to claim 1, wherein the double resonator (50) comprises three mirrors (10, 20, 30).

3. The device (100) according to claim 2, wherein the mirrors (10, 20, 30) are arranged such that a first cavity (15) is formed between a first mirror (10) and a second mirror (20) and a second cavity (25) is formed between the second mirror (20) and a third mirror (30).

4. The device (100) according to claim 2 or 3, wherein at least one of the three mirrors (10, 20, 30) is movable.

5. The device (100) according to claim 3 or 4, wherein the first mirror (10), the active medium (1) and the second mirror (20) are integrally formed, and wherein the third mirror (30) is movable.

6. The device (100) according to any one of claims 3 to 5, wherein the active medium (1) is arranged in the first cavity (15) or in the second cavity (25).

7. The device (100) according to any one of claims 3 to 6, wherein the three mirrors (10, 20, 30) are designed as Bragg mirrors.

8. The device (100) according to any one of claims 3 to 7, further comprising:

    - an optical fiber, which is designed to transport the generated single photon (13), wherein the third mirror (30) is integrated in the optical fiber and/or is designed in the form of a concave and coated end portion of the optical fiber.

9. The device (100) according to any one of claims 3 to 7, wherein
the third mirror (30) is implemented in a layer that is transparent to the single-photon emission, and wherein the device (100) further comprises:

    - an optical fiber, which is designed to transport the generated single photon (13);
    - a lens, which is designed and arranged to couple the generated single photon (13) into the optical fiber.

10. The device (100) according to any one of claims 3 to 9, wherein the following applies for the reflectivity $R_1$ of the first mirror (10), the reflectivity $R_2$ of the second mirror (20) and the reflectivity $R_3$ of the third mirror (30):

$$R_1 > R_3 > R_2 \text{ or } R_3 > R_1 > R_2.$$

11. The device (100) according to any one of the preceding claims, wherein the excitation source (5a; 5b) comprises an excitation light source (5a), which is designed and arranged to irradiate the active medium (1) with excitation light (7) and thus to produce the biexciton ($|XX\rangle$), wherein the excitation light source (5a) and the stimulation light source are preferably arranged such that the beam direction of the excitation light source (5a) and the emission direction of the emitted single photon (13) are orthogonal to one another; and/or
wherein the excitation source (5a; 5b) comprises a voltage source (5b).

12. The device (100) according to any one of the preceding claims,

wherein the wavelength of the emitted single photon (13) is determined by the wavelength of the stimulation light (9), and/or
wherein the polarization of the emitted single photon (13) is determined by the polarization of the stimulation light (9), and/or
wherein the stimulation light source emits pulsed stimulation light (9) and the time course of the waveform of the emitted single photon (13) is determined by the time course of the pulse shape of the stimulation light (9).

13. A method for generating a single-photon emission, comprising the steps of:

    - providing a system (1) that can be excited into a biexciton state;
    - producing a biexciton ($|XX\rangle$) by exciting the system (1);
    - producing a virtual state (8) on the basis of the produced biexciton ($|XX\rangle$) by irradiating the system (1) with stimulation light (9), wherein the virtual state (8) is a state from which a single photon (13) is spontaneously emitted;

wherein the system that can be excited into a biexciton state is provided in a double resonator structure (50), which comprises two settable resonator modes (60, 70), wherein one resonator mode (60) is set to a desired wavelength of the single-photon emission and wherein a second resonator mode (70) is set to the wavelength of the stimulation light (9).

14. The method according to claim 13, wherein the resonator modes (60, 70) are set by moving at least one mirror of the double resonator structure (50).

15. The method according to claim 13 or 14, wherein the wavelength, the polarization and/or the pulse shape of the stimulation light (9) are selected depending on the desired wavelength, polarization and/or pulse shape of the single-photon emission.

**Revendications**

1. Dispositif (100) de génération d'un photon individuel (13), présentant :

    - un milieu actif (1) susceptible d'être excité de manière à passer à un état de biexciton ;
    - une source d'excitation (5a ; 5b) conçue pour générer un biexciton ($|XX\rangle$) sur la base du milieu actif (1) ;
    - une source de lumière de stimulation, conçue et agencée pour irradier le milieu actif (1) avec une lumière de stimulation (9) et ainsi générer un état virtuel (8) sur la base du biexciton ($|XX\rangle$)

généré, à partir duquel le photon individuel (13) peut être émis ;

dans lequel le dispositif présente en outre un double résonateur (50) dans lequel est disposé le milieu actif (1), dans lequel le double résonateur (50) présente deux modes de résonateur couplés (60, 70), dans lequel le premier mode de résonateur (60) est adapté à une longueur d'onde de la source de lumière de stimulation et dans lequel le deuxième mode de résonateur (70) est adapté à une longueur d'onde souhaitée du photon individuel (13) émis.

2. Dispositif (100) selon la revendication 1, dans lequel le double résonateur (50) comporte trois miroirs (10, 20, 30).

3. Dispositif (100) selon la revendication 2, dans lequel les miroirs (10, 20, 30) sont disposés de telle façon qu'une première cavité (15) est formée entre un premier miroir (10) et un deuxième miroir (20) et qu'une deuxième cavité (25) est formée entre le deuxième miroir (20) et un troisième miroir (30).

4. Dispositif (100) selon la revendication 2 ou 3, dans lequel l'un au moins des trois miroirs (10, 20, 30) est déplaçable.

5. Dispositif (100) selon la revendication 3 ou 4, dans lequel le premier miroir (10), le milieu actif (1) et le deuxième miroir (20) sont conçus d'un seul tenant, et dans lequel le troisième miroir (30) est déplaçable.

6. Dispositif (100) selon l'une des revendications 3 à 5, dans lequel le milieu actif (1) est disposé dans le première cavité (15) ou dans la deuxième cavité (25).

7. Dispositif (100) selon l'une des revendications 3 à 6, dans lequel les trois miroirs (10, 20, 30) sont conçus comme des miroirs de Bragg.

8. Dispositif (100) selon l'une des revendications 3 à 7, présentant en outre :

    - une fibre optique conçue pour transporter le photon individuel (13) généré, le troisième miroir (30) étant intégré dans la fibre optique et/ou conçu sous la forme d'une section d'extrémité concave et revêtue de la fibre optique.

9. Dispositif (100) selon l'une des revendications 3 à 7, dans lequel

    - le troisième miroir (30) est réalisé dans une couche transparente à l'émission de photons individuels, le dispositif (100) présentant en outre :
    - une fibre optique conçue pour transporter le photon individuel (13) généré ;
    - une lentille conçue et agencée pour coupler le photon individuel (13) généré dans la fibre optique.

10. Dispositif (100) selon l'une des revendications 3 à 9, dans lequel la règle suivante s'applique à la réflectivité $R_1$ du premier miroir (10), à la réflectivité $R_2$ du deuxième miroir (20) et à la réflectivité $R_3$ du troisième miroir (30) :

$$R_1 > R_3 > R_2 \text{ ou } R_3 > R_1 > R_2.$$

11. Dispositif (100) selon l'une des revendications précédentes,

    dans lequel la source d'excitation (5a ; 5b) comporte une source de lumière d'excitation (5a) conçue et agencée pour irradier le milieu actif (1) avec une lumière d'excitation (7) et ainsi générer le biexciton ($|XX>$),
    dans lequel la source de lumière d'excitation (5a) et la source de lumière de stimulation sont avantageusement disposées de telle façon que la direction de rayonnement de la source de lumière d'excitation (5a) et la direction d'émission du photon individuel (13) émis sont orthogonales l'une par rapport à l'autre ; et/ou
    dans lequel la source d'excitation (5a ; 5b) comporte une source de tension (5b).

12. Dispositif (100) selon l'une des revendications précédentes,

    dans lequel la longueur d'onde du photon individuel (13) émis est déterminée par la longueur d'onde de la lumière de stimulation (9), et/ou
    dans lequel la polarisation du photon individuel (13) émis est déterminée par la polarisation de la lumière de stimulation (9), et/ou
    dans lequel la source de lumière de stimulation émet une lumière de stimulation pulsée (9) et l'évolution temporelle de la forme d'onde du photon individuel (13) émis est déterminée par l'évolution temporelle de la forme d'impulsion de la lumière de stimulation (9).

13. Procédé de génération d'une émission de photons individuels, comportant les étapes suivantes :

    - mise à disposition d'un système (1) susceptible d'être excité de manière à passer à un état de biexciton ;
    - génération d'un biexciton ($|XX>$) par excitation du système (1) ;
    - génération d'un état virtuel (8) sur la base du biexciton (|XX>) généré, par irradiation du système (1) avec une lumière de stimulation (9), l'état virtuel (8) étant un état à partir duquel un photon individuel (13) est émis spontanément ;

dans lequel le système susceptible d'être excité de manière à passer à un état de biexciton est fourni dans une structure de double résonateur (50) présentant deux modes de résonateur (60, 70) réglables, dans lequel un mode de résonateur (60) est réglé sur une longueur d'onde souhaitée de l'émission de photons individuels et dans lequel un deuxième mode de résonateur (70) est réglé sur la longueur d'onde de la lumière de stimulation (9).

14. Procédé selon la revendication 13, dans lequel le réglage des modes de résonateur (60, 70) est effectué par déplacement d'au moins un miroir de la structure de double résonateur (50).

15. Procédé selon la revendication 13 ou 14, dans lequel la longueur d'onde, la polarisation et/ou la forme d'impulsion de la lumière de stimulation (9) sont choisies en fonction de la longueur d'onde, de la polarisation et/ou de la forme d'impulsion souhaitées pour l'émission de photons individuels.

Fig. 1

Fig. 2

Fig. 3

Fig. 4

Fig. 5

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102012007793 A1

**In der Beschreibung aufgeführte Nicht-Patentliteratur**

- **D. HEINZE et al.** A quantum dot single-photon source with on-the-fly all-optical polarization control and timed emission. *Nature Communications,* 2015, vol. 6, 8473

- **DIRK HEINZE et al.** A quantum dot single-photon source with on-the-fly all-optical polarization control and timed emission. Cornell Univ. Library, 02. Dezember 2014